# EUROPEAN PATENT APPLICATION

(11) **EP 4 590 089 A2**
(43) Date of publication of application: **23.07.2025**
(21) Application number: 24222818.7
(22) Date of filing: 23.12.2024
(51) Int. Cl.: H10D 84/80, H10D 84/00

(54) **INTEGRATED CIRCUIT DEVICE AND ELECTRONIC SYSTEM INCLUDING THE SAME**

(30) Priority: 29.12.2023 KR 20230197701
(71) Applicant: Samsung Electronics Co., Ltd., Suwon-si, Gyeonggi-do 16677 (KR)
(72) Inventor: LEE, Sangjae, 16677 Suwon-si, Gyeonggi-do (KR); BAEK, Sungkweon, 16677 Suwon-si, Gyeonggi-do (KR); LEE, Dongjin, 16677 Suwon-si, Gyeonggi-do (KR); LEE, Jaeduk, 16677 Suwon-si, Gyeonggi-do (KR)
(74) Representative: Kuhnen & Wacker Patent- und Rechtsanwaltsbüro PartG mbB

(57) **Abstract**

An integrated circuit device (10) includes a substrate (101), a channel area (62C) arranged in the substrate (101), a gate structure (60G) arranged on the channel area (62C) and including a gate dielectric layer (60D), a gate electrode (60E), and a gate capping layer (60C) which are sequentially stacked, and first and second gate spacers (60S) on first and second respective opposite side walls of the gate dielectric layer (60D), the gate electrode (60E), and the gate capping layer (60C), a source area (62S) and a drain area (62D) arranged at opposite sides of the channel area (62C), a source contact (72S) contacting the source area (62S), a resistance structure (RS) contacting the drain area (62D) and including doped polysilicon, and a drain contact (72D) contacting the resistance structure (RS) and including metal.

## Description

### BACKGROUND

Aspects of the inventive concept relate to an integrated circuit device and an electronic system including the same, and more particularly, to an integrated circuit device including a peripheral circuit transistor and an electronic system including the integrated circuit device.

To meet the demand for excellent performance and economic feasibility, integrated circuit devices have been required to have an increased degree of integration. In particular, the degree of integration of a memory device is a critical factor for determining the economic feasibility of a product including the memory device. The degree of integration of a two-dimensional memory device is mainly determined by an area occupied by a unit memory cell, and thus, is greatly affected by the level of a technique for forming a minute pattern. However, for forming minute patterns, expensive equipment is typically required and an area of a chip die is limited. Thus, despite an increase in the degree of integration of two-dimensional memory devices, the increase is still limited. Accordingly, techniques for increasing the degree of integration of a two-dimensional memory device and techniques for a vertical memory device having a three-dimensional structure are being developed.

### SUMMARY

Aspects of the inventive concept provide an integrated circuit device with a high degree of integration due to forming a resistance structure in a drain area in a vertical direction and thereby replacing a field relaxation transistor (FRT) arranged in a horizontal direction, and an electronic system including the integrated circuit device.

The objectives of the inventive concept are not limited to those mentioned above, and other unmentioned obj ectives will be clearly understood by one of ordinary skill in the art from the descriptions below.

According to an aspect of the inventive concept, an integrated circuit device includes a substrate, a channel area arranged in the substrate, a gate structure arranged on the channel area and including a gate dielectric layer, a gate electrode, and a gate capping layer which are sequentially stacked, and first and second gate spacers on first and second respective opposite side walls of the gate dielectric layer, the gate electrode, and the gate capping layer, a source area and a drain area arranged at opposite sides of the channel area, a source contact contacting the source area, a resistance structure contacting the drain area and including doped polysilicon, and a drain contact contacting the resistance structure and including metal.

According to another aspect of the inventive concept, an integrated circuit device includes a peripheral circuit structure and a cell array structure above the peripheral circuit structure, wherein the peripheral circuit structure includes a circuit substrate, a peripheral circuit transistor on the circuit substrate, a lower line connected to the peripheral circuit transistor, and a first insulating layer covering the peripheral circuit transistor and the lower line, and the cell array structure includes a gate stack including a plurality of gate electrodes and a plurality of insulating layers, the plurality of gate electrodes and the plurality of insulating layers being alternately stacked, a plurality of channel structures extending by passing through the gate stack, and a second insulating layer covering the gate stack, wherein the peripheral circuit transistor includes a channel area arranged in the circuit substrate, a gate structure arranged on the channel area and including a gate dielectric layer, a gate electrode, and a gate capping layer which are sequentially stacked, and first and second gate spacers on first and second respective opposite side walls of the gate dielectric layer, the gate electrode, and the gate capping layer, a source area and a drain area arranged at opposite sides of the channel area, a source contact contacting the source area, and a resistance structure contacting the drain area and a drain contact contacting the resistance structure.

According to another aspect of the inventive concept, an electronic system includes a main substrate, an integrated circuit device on the main substrate, and a controller electrically connected to the integrated circuit device on the main substrate. The integrated circuit device includes a peripheral circuit structure and a cell array structure arranged on the peripheral circuit structure, wherein the peripheral circuit structure includes a circuit substrate, a peripheral circuit transistor on the circuit substrate, a lower line connected to the peripheral circuit transistor, and a first insulating layer covering the peripheral circuit transistor and the lower line, and the cell array structure includes a gate stack including a plurality of gate electrodes and a plurality of insulating layers, the plurality of gate electrodes and the plurality of insulating layers being alternately stacked, a plurality of channel structures extending by passing through the gate stack, and a second insulating layer covering the gate stack. The peripheral circuit transistor includes a channel area arranged in the circuit substrate, a gate structure arranged on the channel area and including a gate dielectric layer, a gate electrode, and a gate capping layer which are sequentially stacked, and a gate spacers on opposite side walls of the gate dielectric layer, the gate electrode, and the gate capping layer, a source area and a drain area arranged at opposite sides of the channel area, a source contact contacting the source area, and a resistance structure contacting the drain area and a drain contact contacting the resistance structure.

### BRIEF DESCRIPTION OF THE DRAWINGS

Embodiments will be more clearly understood from the following detailed description taken in conjunction with the accompanying drawings in which:
FIG. 1 is a schematic plan view of structural elements of an integrated circuit device according to an embodiment;
FIG. 2 is a cross-sectional view of an integrated circuit device, taken along line A-A' of FIG. 1;
FIGS. 3 to 5 are cross-sectional views of integrated circuit devices according to some embodiments;
FIG. 6 is a flowchart of a method of manufacturing an integrated circuit device, according to an embodiment;
FIGS. 7 to 17 are cross-sectional views for illustrating, according to a process order, a method of manufacturing an integrated circuit device, according to an embodiment;
FIG. 18 is a block diagram of a three-dimensional integrated circuit device according to an embodiment;
FIG. 19 is an equivalent circuit diagram of a memory cell array of a three-dimensional integrated circuit device according to an embodiment;
FIG. 20 is a schematic plan view of structural elements of a three-dimensional integrated circuit device according to an embodiment;
FIG. 21 is a cross-sectional view of a three-dimensional integrated circuit device, taken along line B-B' of FIG. 20;
FIG. 22 is an enlarged view of region CC of FIG. 21;
FIG. 23 is an enlarged view of region DD of FIG. 21;
FIG. 24 is an enlarged view of region EE of FIG. 21;
FIGS. 25 and 26 are cross-sectional views of three-dimensional integrated circuit devices according to some embodiments;
FIG. 27 is a diagram of an electronic system including an integrated circuit device, according to an embodiment;
FIG. 28 is a perspective view of an electronic system including an integrated circuit device, according to an embodiment; and
FIGS. 29 and 30 are cross-sectional views of a semiconductor package including an integrated circuit device, according to an embodiment.

### DETAILED DESCRIPTION OF THE EMBODIMENTS

Hereinafter, embodiments of the inventive concept will be described in detail by referring to the accompanying drawings.

Throughout the specification, when a component is described as "including" a particular element or group of elements, it is to be understood that the component is formed of only the element or the group of elements, or the element or group of elements may be combined with additional elements to form the component, unless the context clearly and/or explicitly describes the contrary. The term "consisting of," on the other hand, indicates that a component is formed only of the element(s) listed.

It will be understood that when an element is referred to as being "connected" or "coupled" to or "on" another element, it can be directly connected or coupled to or on the other element or intervening elements may be present. In contrast, when an element is referred to as being "directly connected" or "directly coupled" to another element, or as "contacting" or "in contact with" another element (or using any form of the word "contact"), there are no intervening elements present at the point of contact.

Terms such as "same," "equal," "planar," "coplanar," "parallel," and "perpendicular," as used herein encompass identicality or near identicality including variations that may occur resulting from conventional manufacturing processes. The term "substantially" may be used herein to emphasize this meaning, unless the context or other statements indicate otherwise.

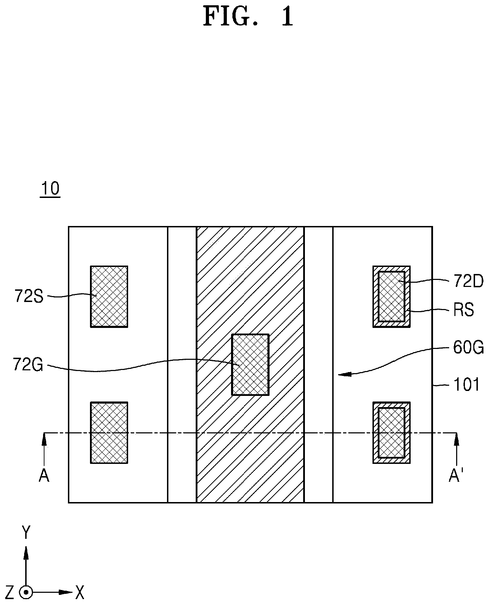

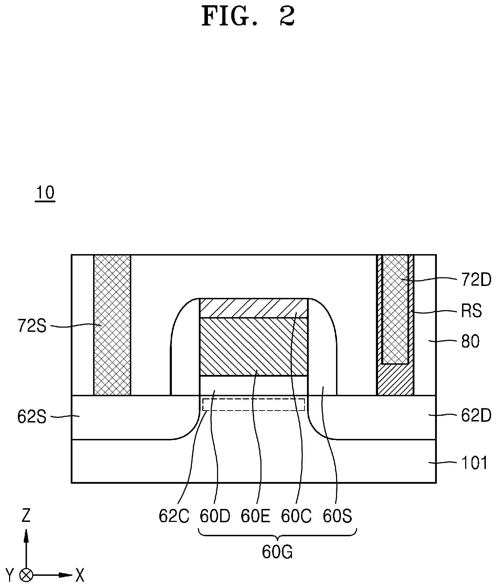

FIG. 1 is a schematic plan view of structural elements of an integrated circuit device 10 according to an embodiment. FIG. 2 is a cross-sectional view of the integrated circuit device 10, taken along line A-A' of FIG. 1.

Referring to FIGS. 1 and 2, the integrated circuit device 10 may include a channel area 62C, a source area 62S, and a drain area 62D arranged in the substrate 101 and a gate structure 60G, a source contact 72S, a drain contact 72D, and a resistance structure RS arranged on the substrate 101.

According to some embodiments, the substrate 101 may include silicon, for example, monocrystalline silicon, polycrystalline silicon, or amorphous silicon. According to some embodiments, the substrate 101 may include at least one selected from among Ge, SiGe, SiC, GaAs, InAs, and InP. According to some embodiments, the substrate 101 may include a conductive area, for example, a well doped with impurities or a structure doped with impurities.

In the substrate 101, the channel area 62C, the source area 62S, and the drain area 62D may be arranged, wherein the source area 62S and the drain area 62D may be arranged at opposite sides of the channel area 62C in a first direction (an X direction). According to some embodiments, the source area 62S and the drain area 62D may be formed by an ion-injection process using the gate structure 60G as a mask. Accordingly, the source area 62S and the drain area 62D may be formed at opposite sides of the gate structure 60G, respectively, in the substrate 101, and the channel area 62C may be defined below the gate structure 60G.

According to some embodiments, the source area 62S and the drain area 62D may use a gate spacer 60S as an ion mask. For example, the source area 62S and the drain area 62D may also be formed by first and second ion-injection processes performed before and after the gate spacer 60S is formed.

The integrated circuit device 10 may include an nMOS region and a pMOS region. The source area 62S and the drain area 62D formed in the nMOS region of the integrated circuit device 10 and the source area 62S and the drain area 62D formed in the pMOS region of the integrated circuit device 10 may have different conductivity types from each other. In detail, each of the source area 62S and the drain area 62D in the pMOS region may have p-type conductivity. Also, each of the source area 62S and the drain area 62D in the nMOS region may have n-type conductivity.

According to some embodiments, the channel area 62C arranged below the gate structure 60G may have the same type conductivity as the substrate 101 arranged therebelow and may have different type conductivity from the source area 62S and the drain area 62D formed therearound.

On the substrate 101, the gate structure 60G extending lengthwise in a second direction (a Y direction) may be arranged above the channel area 62C. An item, layer, or portion of an item or layer described as extending "lengthwise" in a particular direction has a length in the particular direction and a width perpendicular to that direction, where the length is greater than the width. The gate structure 60G may include a gate dielectric layer 60D, a gate electrode 60E, a gate capping layer 60C, and the gate spacer 60S (e.g., two gate spacers).

The gate dielectric layer 60D may be arranged on the channel area 62C. The gate dielectric layer 60D may include silicon oxide, silicon oxynitride, or a high-dielectric material having a higher dielectric constant than silicon oxide, or a combination thereof. The high-dielectric material may include metal oxide or metal oxynitride. For example, the high-dielectric material which may be included in the gate dielectric layer 60D may include HfO₂, HfSiO, HfSiON, HfTaO, HfTiO, HfZrO, ZrO₂, Al₂O₃, or a combination thereof but is not limited thereto.

The gate electrode 60E may be arranged on the gate dielectric layer 60D. The gate electrode 60E may include doped polysilicon, metal, or a combination thereof.

The gate capping layer 60C may be arranged on the gate electrode 60E. The gate capping layer 60C may cover an upper surface of the gate electrode 60E and may extend in the second direction (the Y direction). For example, the gate capping layer 60C may include silicon nitride.

A gate spacer 60S may be arranged at both (e.g., opposite) side walls of the gate dielectric layer 60D, the gate electrode 60E, and the gate capping layer 60C and may extend in the second direction (the Y direction). There may be two gate spacers 60S for each gate structure 60G, including a first gate spacer 60S on a first, combined, side wall of the gate dielectric layer 60D, the gate electrode 60E, and the gate capping layer 60C, and a second gate spacer 60S on a second, combined, side wall of the gate dielectric layer 60D, the gate electrode 60E, and the gate capping layer 60C opposite the first, combined, side wall. According to some embodiments, the gate spacer 60S may include silicon oxide, silicon nitride, silicon oxynitride, silicon carbon nitride, silicon oxycarbonitride, or a combination thereof.

According to some embodiments, the gate spacer 60S may include a plurality of layers including different materials from each other. In FIG. 2, it is illustrated that the gate spacer 60S includes a single layer. However, unlike this, the gate spacer 60S may include a first spacer layer (not shown), a second spacer layer (not shown), and a third spacer layer (not shown) sequentially stacked on the side walls of the gate dielectric layer 60D, the gate electrode 60E, and the gate capping layer 60C. According to some embodiments, the first spacer layer and the third spacer layer may include silicon nitride, silicon oxide, or silicon oxynitride. The second spacer layer may include an insulating material having a lower dielectric constant than the first spacer layer. For example, the second spacer layer may include an air space (i.e., air gap).

An interlayer insulating layer 80 covering the gate structure 60G may be arranged on the substrate 101. The interlayer insulating layer 80 may include silicon nitride, silicon oxide, silicon oxynitride, a TEOS layer, or an ultra-low-k (ULK) layer having an ultra-low dielectric constant of about 2.2 to about 2.4.

The integrated circuit device 10 may include different contact structures. For example, in one embodiment, the source contact 72S passes through the interlayer insulating layer 80 and is electrically connected to the source area 62S. Also, in one embodiment, the drain contact 72D passes through the interlayer insulating layer 80 and is electrically connected to the drain area 62D. Also, in one embodiment, the gate contact 72G passes through the interlayer insulating layer 80 and the gate capping layer 60C and is electrically connected to the gate electrode 60E.

Each of the contact structures, namely, the source contact 72S, the drain contact 72D, and the gate contact 72G, may include metal, metal nitride, metal silicide, or a combination thereof. For example, the source contact 72S, the drain contact 72D, and the gate contact 72G may be formed as a double-layered structure including a metal buried layer (not shown) and a conductive barrier layer (not shown) surrounding a side surface and a bottom surface of the metal buried layer. For example, the metal buried layer may include at least one of Co, W, Ni, Ru, Gu, Al, a silicide thereof, and an alloy thereof, and the conductive barrier layer may include Ti, Ta, Ru, TiN, TaN, or a combination thereof, but the metal buried layer and the conductive barrier layer are not limited thereto.

In FIG. 1, it is illustrated that one gate contact 72G may be arranged at the center of the gate structure 60G, and two source contacts 72S and two drain contacts 72D may be arranged at both sides of the gate structure 60G, respectively. However, unlike this, two or more gate contacts 72G may be arranged at the center of the gate structure 60G, and three or more source contacts 72S and three or more drain contacts 72D may be arranged at both sides of the gate structure 60G, respectively.

The integrated circuit device 10 according to the inventive concept may include the resistance structure RS that is in contact with the drain area 62D and includes doped polysilicon. The resistance structure RS may be formed by including doped polysilicon which has a relatively higher resistance than metal, so that the resistance on the drain area 62D may be increased. Accordingly, a first resistance of the source contact 72S on the source area 62S in which the resistance structure RS is not arranged may be less than a second resistance of the combined drain contact 72D and resistance structure RS on the drain area 62D in which the resistance structure RS is arranged. The combined drain contact 72D and resistance structure RS may form a contact, described as a through electrode, which has a different resistance from the contact (e.g., through electrode) that comprises the source contact 72S. The component that connects the source area 62S to another wiring layer may be generally described as a source through electrode, and the component that connects the drain area 62D to another wiring layer may be generally described as drain through electrode. In the example of FIGS. 1 and 2, the source through electrode may be source contact 72S and the drain through electrode may be the combination of drain contact 72D and resistance structure RS.

Here, the resistance of the resistance structure RS may vary according to the integrated circuit device 10 and may be determined by at least one of a doping concentration of the doped polysilicon included in the resistance structure RS, a crystal grain size of the doped polysilicon, and a thickness of the doped polysilicon.

The resistance structure RS may be contact each of the drain area 62D and the drain contact 72D. A first interface between the resistance structure RS and the drain area 62D and a second interface between the resistance structure RS and the drain contact 72D may not include substantially different materials from each other. In particular, a silicide layer may not be formed on the second interface between the resistance structure RS and the drain contact 72D.

According to some embodiments, the source contact 72S, the drain contact 72D, and the gate contact 72G may be formed in the same process as one another by including substantially the same material as one another. Accordingly, the source contact 72S and the gate contact 72G may likewise include metal, metal nitride, metal silicide, or a combination thereof included in the drain contact 72D. However, the source contact 72S and the gate contact 72G may not include the doped polysilicon included in the resistance structure RS.

In the integrated circuit device 10 according to an embodiment, the resistance structure RS may have a U-shape from a cross-sectional view, having a groove at the center thereof, and the drain contact 72D may be arranged to fill the groove of the resistance structure RS. Also, a vertical level of an uppermost surface of the resistance structure RS and a vertical level of an uppermost surface of the drain contact 72D may be substantially the same as each other. From a three-dimensional aspect, the resistance structure RS may have a cup-shape, including an internal hole filled with the drain contact 72D. The cup-shape may have square or rectangular side walls, or round side walls.

According to some embodiments, a maximum width of the resistance structure RS in the first direction (the X direction) may be greater than a maximum width of the drain contact 72D in the first direction (the X direction). For example, the drain contact 72D may only be arranged in the groove of the resistance structure RS. The resistance structure RS may be described as a drain contact cover or a drain contact shell, which surrounds the drain contact 72D. Also, more generally, as described in the various embodiments, the resistance structure may be described as a resistor via, for example, functioning as a resistor or higher-resistance region between the drain contact 72D and the drain area 62D.

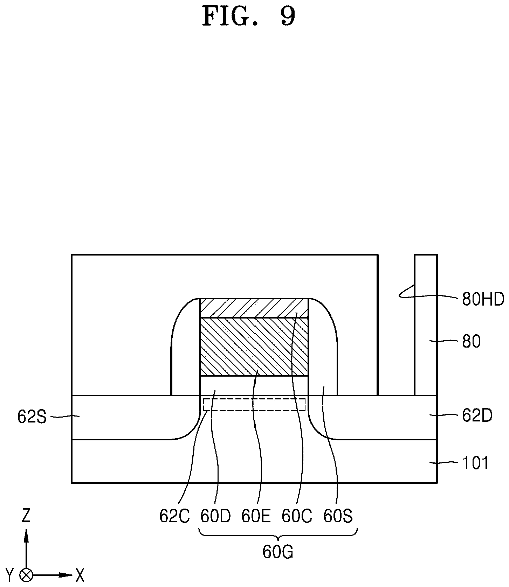

According to some embodiments, the resistance structure RS may include a bottom portion and side walls arranged on the bottom portion, and a thickness of the bottom portion in a vertical direction (a Z direction) may have a greater value than a width of any one of the side walls in the first direction (the X direction). The side walls may be on each of four sides of the drain contact 72D, as indicated in FIG. 1, and may therefore be formed on opposite side walls of the drain contact 72D in each of two horizontal directions (e.g., the X direction and the Y direction). Though a rectangular-shaped resistance structure RS is depicted, this is just one example, and the shape of the drain contact 72D and resistance structure RS from a plan view may be circular, oval, or other shapes. Therefore, in some examples, the resistance structure RS may have a single continuous side wall having different sections. When viewed from a cross-sectional view from a horizontal direction, these side walls may described as separate side walls (even if they are part of a continuously curved single sidewall). The widths described above may be the characteristics of a manufacturing process filling a drain contact hole 80HD (see FIG. 9) having a high aspect ratio.

To satisfy the criterion of excellent performance and economic feasibility, it has typically been required to increase the degree of integration of integrated circuit devices. In particular, the degree of integration of a memory device is an important factor for determining economic feasibility of a product. The degree of integration of a two-dimensional integrated circuit is mainly determined by an area occupied by a unit memory cell.

In general, an operation transistor, which is a two-dimensional integrated circuit device, may use a field relaxation transistor (FRT) arranged in a horizontal direction as a resistor, so that a voltage applied to a drain area of the operation transistor becomes less than a drain voltage Vd. Thus, degradation of reliability of the operation transistor due to a lateral field effect caused by the drain voltage Vd may be reduced. However, in this case, while the reliability degradation is reduced, the degree of integration may be hampered in accordance with an area occupied by the FRT.

Thus, in the integrated circuit device 10 according to an embodiment of the inventive concept, the resistance structure RS may be formed on the drain area 62D in the vertical direction (the Z direction) to replace the FRT in the first direction (the X direction), and thus, an area occupied by the FRT according to the related art may be reduced.

Consequently, the integrated circuit device 10 according to the inventive concept may improve the electrical characteristics (for example, reliability degradation) of the operation transistor and may also realize a high degree of integration of the two-dimensional operation transistor.

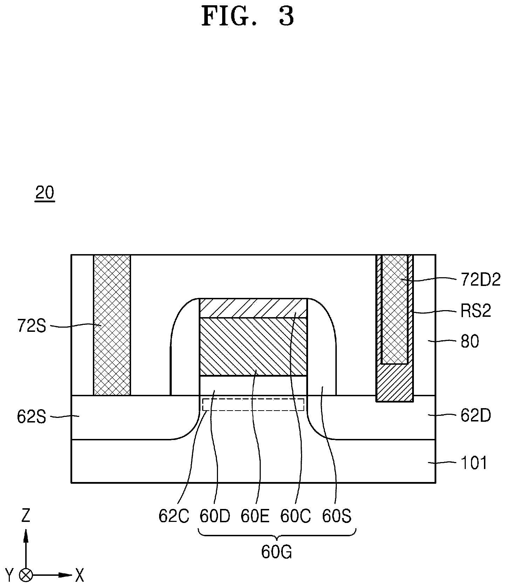

FIGS. 3 to 5 are cross-sectional views of integrated circuit devices 20, 30, and 40 according to some embodiments.

Most of the elements included in the integrated circuit devices 20, 30, and 40 described hereinafter and the materials included in the elements may be substantially the same or similar as described above with reference to FIGS. 1 and 2. Thus, for convenience of explanation, descriptions will be given based on the differences from the integrated circuit device 10 described above.

Referring to FIG. 3, the integrated circuit device 20 may include the channel area 62C, the source area 62S, and the drain area 62D arranged in the substrate 101 and the gate structure 60G, the source contact 72S, the drain contact 72D2, and a resistance structure RS2 arranged on the substrate 101.

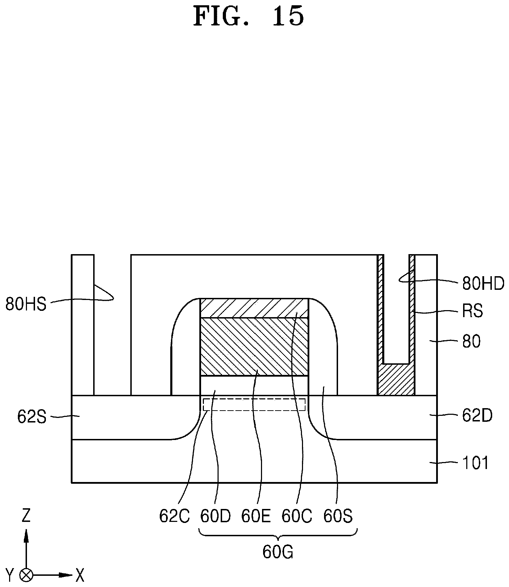

In the integrated circuit device 20 according to an embodiment, the source contact 72S may be in contact on the same plane with an upper surface of the source area 62S, and the resistance structure RS2 may downwardly extend beyond an upper surface of the drain area 62D in a vertical direction (a Z direction). Accordingly, a vertical level of a lowermost surface of the source contact 72S may be higher than a vertical level of a lowermost surface of the resistance structure RS2. This may be the characteristics of a manufacturing process, in which a drain contact hole 80HD (see FIG. 9) and a source contact hole 80HS (see FIG. 15) are formed in different processes.

According to some embodiments, from a cross-sectional view, the resistance structure RS2 may have a U-shape having a groove at the center thereof, and a drain contact 72D2 may be arranged to fill the groove of the resistance structure RS2. Also, a vertical level of an uppermost surface of the resistance structure RS2 and a vertical level of an uppermost surface of the drain contact 72D2 may be substantially the same as each other. From a three-dimensional aspect, the resistance structure RS2 may have a cup-shape, including an internal hole filled with the drain contact 72D2.

According to some embodiments, a maximum width of the resistance structure RS2 in a first direction (an X direction) may be greater than a maximum width of the drain contact 72D2 in the first direction (the X direction). That is, the drain contact 72D2 may only be arranged in the groove of the resistance structure RS2.

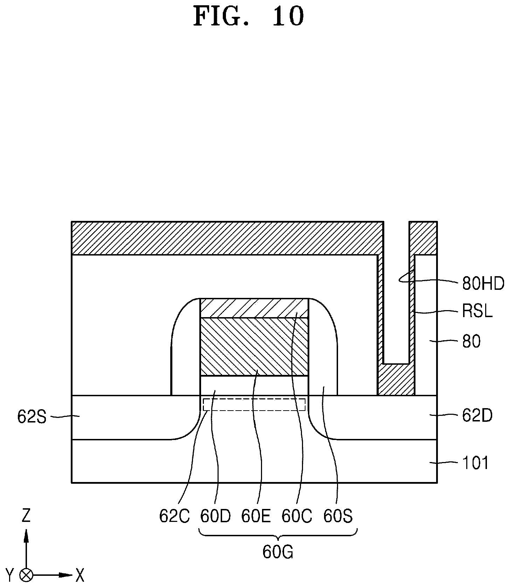

According to some embodiments, the resistance structure RS2 may include a bottom portion and side walls arranged on the bottom portion, and a thickness of the bottom portion in the vertical direction (the Z direction) may have a greater value than a width of any one of the side walls in the first direction (the X direction). This may be the characteristics of a manufacturing process filling a drain contact hole 80HD (see FIG. 10) having a high aspect ratio.

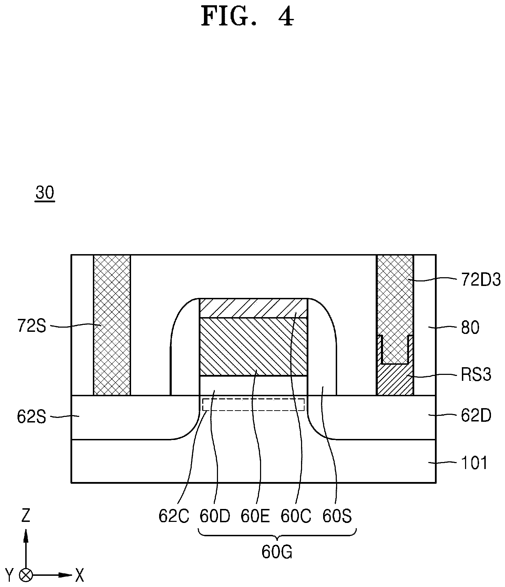

Referring to FIG. 4, the integrated circuit device 30 may include the channel area 62C, the source area 62S, and the drain area 62D arranged in the substrate 101 and the gate structure 60G, the source contact 72S, a drain contact 72D3, and a resistance structure RS3 arranged on the substrate 101.

In the integrated circuit device 30 according to an embodiment, the resistance structure RS3 may have a U-shape having a groove at the center thereof (e.g., a cup-shape from a three-dimensional perspective), and the drain contact 72D3 may be arranged to fill the groove of (e.g., hole in) the resistance structure RS3. Also, a vertical level of an uppermost surface of the resistance structure RS3 may be lower than a vertical level of an uppermost surface of the drain contact 72D3.

According to some embodiments, a maximum width of the resistance structure RS3 in a first direction (an X direction) may be substantially the same as a maximum width of the drain contact 72D3 in the first direction (the X direction). That is, the drain contact 72D3 may be arranged above the groove of the resistance structure RS3.

According to some embodiments, the resistance structure RS3 may include a bottom portion and side walls arranged on the bottom portion, and a thickness of the bottom portion in a vertical direction (a Z direction) may have a greater value than a width of any one of the side walls in the first direction (the X direction). This may be the characteristics of a manufacturing process filling the drain contact hole 80HD (see FIG. 10) having a high aspect ratio.

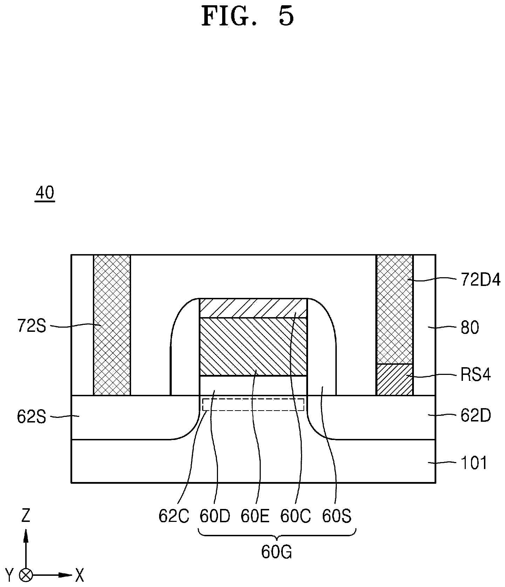

Referring to FIG. 5, the integrated circuit device 40 may include the channel area 62C, the source area 62S, and the drain area 62D arranged in the substrate 101 and the gate structure 60G, the source contact 72S, a drain contact 72D4, and a resistance structure RS4 arranged on the substrate 101.

In the integrated circuit device 40 according to an embodiment, the resistance structure RS4 may have a rectangular shape, and the drain contact 72D4 may have another rectangular shape completely covering an upper surface of the resistance structure RS4. For example, both rectangular shapes may be solid rectangular shapes.

According to some embodiments, a maximum width of the resistance structure RS4 in a first direction (an X direction) may be substantially the same as a maximum width of the drain contact 72D4 in the first direction (the X direction). That is, the drain contact 72D4 and the resistance structure RS4 may have the rectangular shapes having different lengths in a vertical direction (a Z direction) from each other.

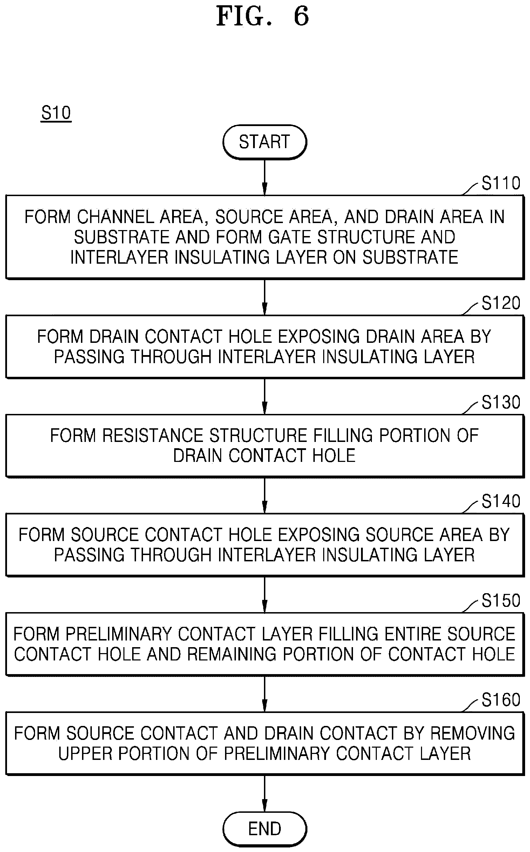

FIG. 6 is a flowchart of a method of manufacturing an integrated circuit device, according to an embodiment.

Referring to FIG. 6, the method S10 of manufacturing an integrated circuit device may include a process order of first to sixth operations S110 to S160.

When a certain embodiment is differently realized, a specific order of operations may be different from the described orders. For example, two operations sequentially described may be substantially and simultaneously performed or may be performed in orders opposite to the described orders.

The method S10 of manufacturing an integrated circuit device, according to an embodiment of the inventive concept, may include the first operation S110 of forming a channel area, a source area, and a drain area in a substrate and forming a gate structure and an interlayer insulating layer on the substrate, a second operation S 120 of forming a drain contact hole passing through the interlayer insulating layer and exposing the drain area, a third operation S130 of forming a resistance structure filling a portion of the drain contact hole, a fourth operation S 140 of forming a source contact hole passing through the interlayer insulating layer and exposing the source area, a fifth operation S150 of forming a preliminary contact layer filling the entire source contact hole and a remaining portion of the drain contact hole, and a sixth operation S160 of forming a source contact and a drain contact by removing an upper portion of the preliminary contact layer.

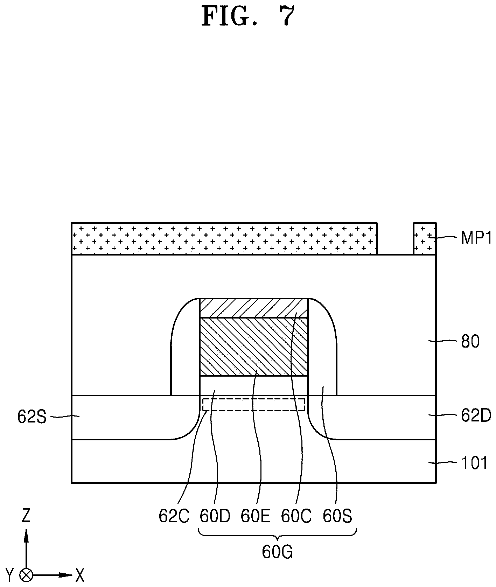

The technical characteristics with respect to each of the first to sixth operations S110 to S160 will be described in detail with reference to FIGS. 7 to 17 below.

FIGS. 7 to 17 are cross-sectional views for illustrating, according to a process order, a method of manufacturing an integrated circuit device, according to an embodiment.

Referring to FIG. 7, a preliminary gate dielectric layer (not shown), a preliminary gate electrode layer (not shown), and the gate capping layer 60C may be sequentially formed on the substrate 101.

The preliminary gate electrode layer and the preliminary gate dielectric layer may be patterned by using the gate capping layer 60C as an etch mask, to form the gate electrode 60E and the gate dielectric layer 60D.

Next, a spacer insulating layer (not shown) covering the gate capping layer 60C, the gate electrode 60E, and the gate dielectric layer 60D may be formed by using an atomic layer deposition (ALD) process or a chemical vapor deposition (CVD) process, and an anisotropic etch process may be performed on the spacer insulating layer to form the gate spacer 60S on side walls of the gate capping layer 60C, the gate electrode 60E, and the gate dielectric layer 60D. Thus, the gate structure 60G may be formed on the substrate 101.

Here, the channel area 62C, the source area 62S, and the drain area 62D arranged in the substrate 101 may be formed by ion-injection processes performed before, during, and/or after the formation of the gate structure 60G.

Next, the interlayer insulating layer 80 covering the gate structure 60G may be formed on the substrate 101. Next, a first mask pattern MP1 may be formed on the interlayer insulating layer 80. The first mask pattern MP1 may be formed to have a desired pattern, by using an exposure process and a development process.

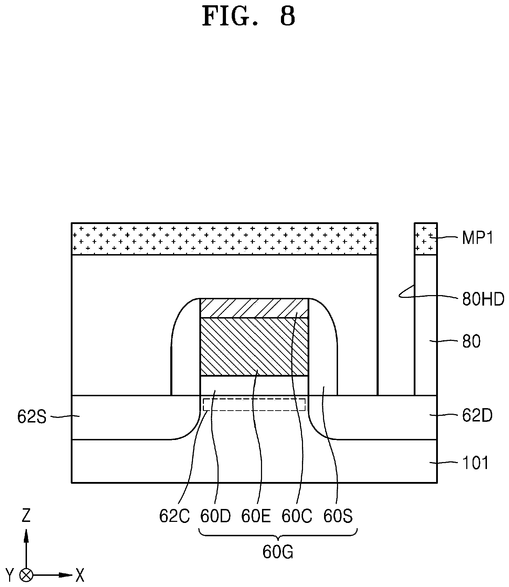

Referring to FIG. 8, the drain contact hole 80HD passing through the interlayer insulating layer 80 and exposing an upper surface of the drain area 62D may be formed by using the first mask pattern MP1 as an etch mask.

Referring to FIG. 9, the first mask pattern MP1 (see FIG. 8) may be removed by ashing process and stripping process. The first mask pattern MP1 (see FIG. 8) may be generally a photoresist pattern and may be completely removed by the process above.

Referring to FIG. 10, a preliminary resistance structure layer RSL filling the drain contact hole 80HD may be formed on the interlayer insulating layer 80. The preliminary resistance structure layer RSL may include doped polysilicon. According to some embodiments, based on a high aspect ratio of the drain contact hole 80HD, a thickness of a side wall of the preliminary resistance structure layer RSL may be less than a thickness of a bottom portion thereof.

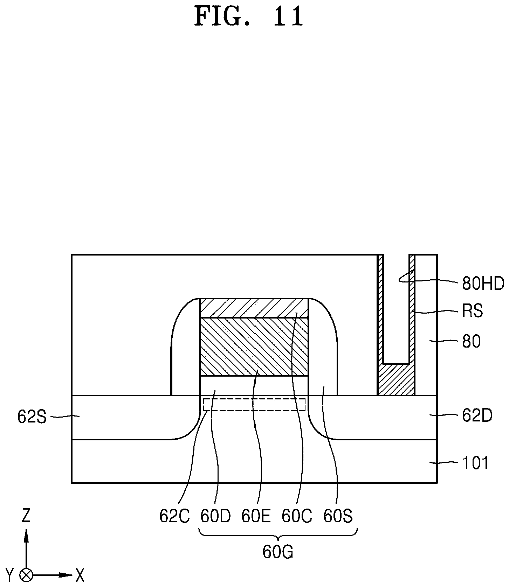

Referring to FIG. 11, until an upper surface of the interlayer insulating layer 80 is exposed, an upper portion of the preliminary resistance structure layer RSL (see FIG. 10) may be removed, to form the resistance structure RS filling a portion of the drain contact hole 80HD. Accordingly, the resistance structure RS may be formed to have a U-shape having a groove at the center thereof (as viewed from a cross-sectional view), or to have a cup shape having a hole formed therein (as viewed from three-dimensional perspective).

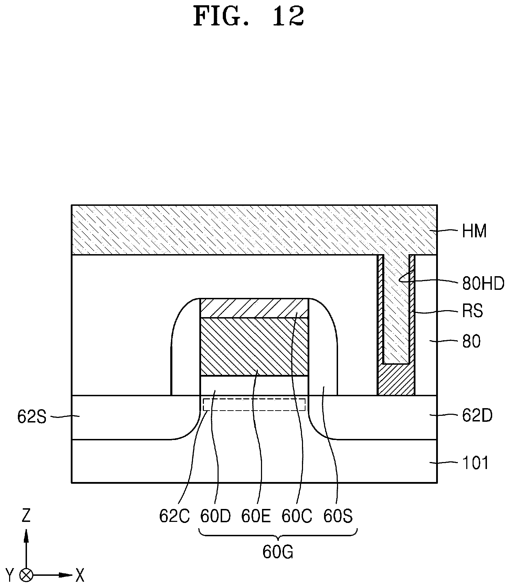

Referring to FIG. 12, a hard mask HM filling a remaining portion of the drain contact hole 80HD may be formed on the interlayer insulating layer 80. The hard mask HM may include, for example, a carbon-based material. In detail, the hard mask HM may include a spin-on hard mask (SOH), or the like, which is a layer including an amorphous carbon layer (ACL) or a hydrocarbon compound or derivatives thereof, the hydrocarbon compound having a relatively increased carbon content of about 85 weight percent to about 99 weight percent with respect the total weight percent.

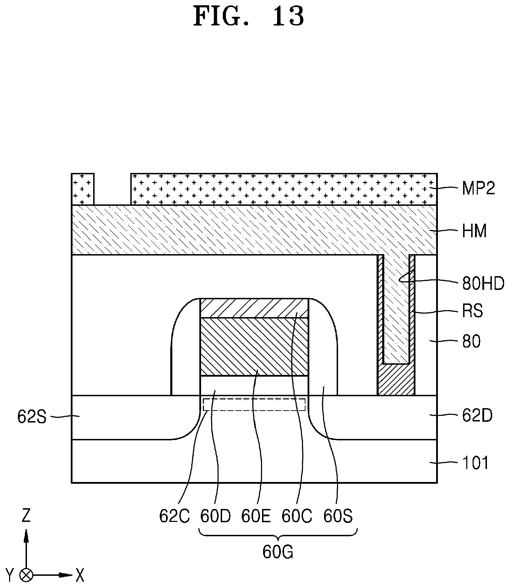

Referring to FIG. 13, a second mask pattern MP2 may be formed on the hard mask HM. The second mask pattern MP2 may be formed to have a desired pattern, by using an exposure process and a development process.

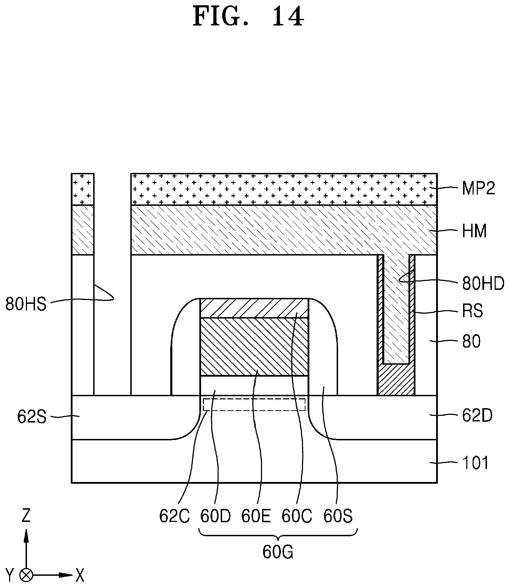

Referring to FIG. 14, by using the second mask pattern MP2 as an etch mask, a source contact hole 80HS passing through the hard mask HM and the interlayer insulating layer 80 and exposing an upper surface of the source area 62S may be formed. Although not shown, in the process of forming the source contact hole 80HS, a gate contact hole (not shown) exposing an upper surface of the gate electrode 60E may also be formed.

Referring to FIG. 15, the second mask pattern MP2 (see FIG. 14) and the hard mask HM (see FIG. 14) may be removed by ashing process and stripping process. The second mask pattern MP2 (see FIG. 14) may be generally a photoresist pattern and may be completely removed by the process above.

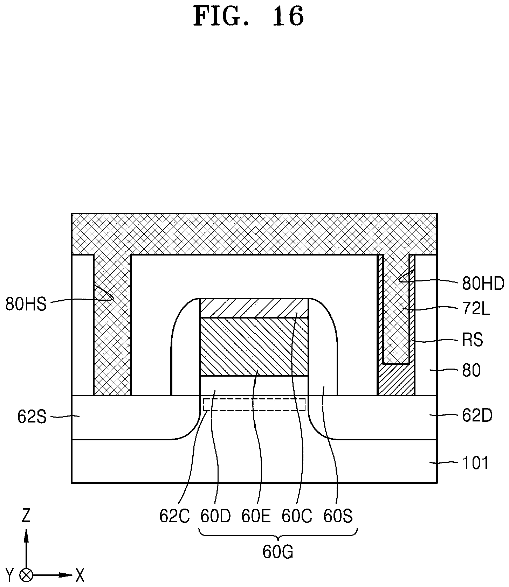

Referring to FIG. 16, a preliminary contact layer 72L filling the source contact hole 80HS and the drain contact hole 80HD may be formed on the interlayer insulating layer 80. The preliminary contact layer 72L may include metal, metal nitride, metal silicide, or a combination thereof. Here, a silicide layer may not be formed on an interface between the preliminary contact layer 72L and the resistance structure RS.

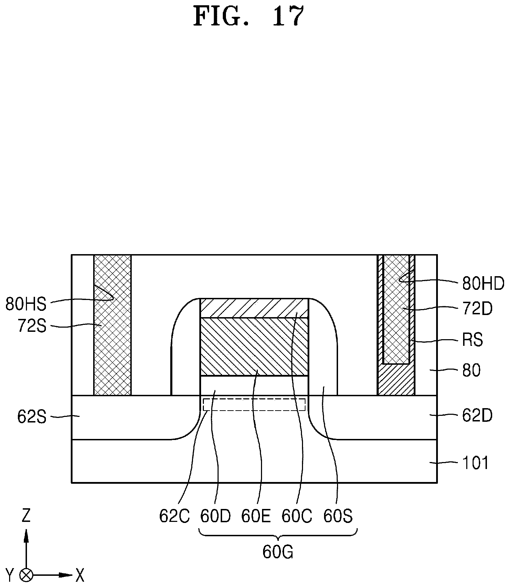

Referring to FIG. 17, until an upper surface of the interlayer insulating layer 80 is exposed, an upper portion of the preliminary contact layer 72L (see FIG. 16) may be removed to form the source contact 72S completely filling the source contact hole 80HS and the drain contact 72D filling a remaining portion of the drain contact hole 80HD. Although not shown, in the process of forming the source contact 72S and the drain contact 72D, the gate contact 72G (see FIG. 1) may also be formed (e.g., as part of the first mask pattern MP1 or the second mask pattern MP2).

According to the method of manufacturing an integrated circuit device described above, the integrated circuit device 10 according to an embodiment may be manufactured.

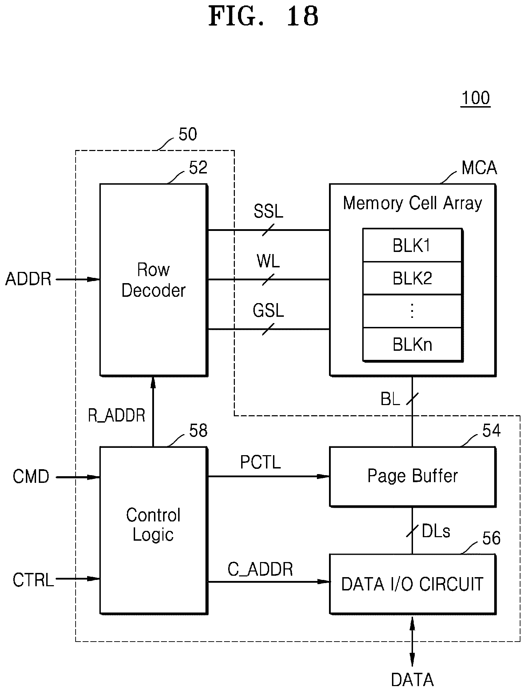

FIG. 18 is a block diagram of a three-dimensional integrated circuit device 100 according to an embodiment.

Referring to FIG. 18, the integrated circuit device 100 may include a memory cell array MCA and a peripheral circuit 50, and may be part of a semiconductor device such as a semiconductor memory chip or semiconductor memory package.

The memory cell array MCA may include a plurality of memory cell blocks BLK1, BLK2, ..., and BLKn. Each of the plurality of memory cell blocks BLK1, BLK2, ..., and BLKn may include a plurality of memory cells. The plurality of memory cell blocks BLK1, BLK2, ..., and BLKn may be connected to the peripheral circuit 50 through a bit line BL, a word line WL, a string selection line SSL, and a ground selection line GSL.

The memory cell array MCA may be connected to a page buffer 54 through the bit line BL and may be connected to a row decoder 52 through the word line WL, the string selection line SSL, and the ground selection line GSL. In the memory cell array MCA, the plurality of memory cells included in the plurality of memory cell blocks BLK1, BLK2, ..., and BLKn may be flash memory cells. The memory cell array MCA may include a three-dimensional memory cell array. The three-dimensional memory cell array may include a plurality of NAND strings, and each NAND string may include a plurality of memory cells connected to a plurality of word lines WL vertically stacked.

The peripheral circuit 50 may include the row decoder 52, a page buffer 54, a data input and output circuit 56, and a control logic 58. Although not shown, the peripheral circuit 50 may further include a voltage generation circuit configured to generate various voltages required for operation of the integrated circuit device 100, an error correction circuit configured to correct an error of data read from the memory cell array MCA, and various circuits, such as an input and output interface.

The peripheral circuit 50 may receive an address ADDR, a command CMD, and a control signal CTRL from the outside of the integrated circuit device 100 and may transmit and receive data DATA to and from a device outside the integrated circuit device 100. The configurations of the peripheral circuit 50 are described in detail as below.

The row decoder 52 may select at least one of the plurality of memory cell blocks BLK1, BLK2, ..., and BLKn in response to an address ADDR from the outside and may select a word line WL, a string selection line SSL, and a ground selection line GSL of the selected memory cell block. The row decoder 52 may transmit a voltage for performing a memory operation to the word line WL of the selected memory cell block.

The page buffer 54 may be connected to the memory cell array MCA through the bit line BL. The page buffer 54 may operate, during a program operation, as a write driver and apply, to the bit line BL, a voltage according to data DATA to be stored in the memory cell array MCA and may operate, during a read operation, as a sense amplifier and sense the data DATA stored in the memory cell array MCA. The page buffer 54 may operate according to a control signal PCTL provided from the control logic 58. One or more transistors included in the row decoder 52, control logic 58, page buffer 54, data input and output circuit 56, or memory cell array MCA may include a planar transistor having the structure of any of FIGS. 1-6.

The data input and output circuit 56 may be connected to the page buffer 54 through data lines DLs. During a program operation, the data input and output circuit 56 may receive data DATA from a memory controller (not shown) and provide program data DATA to the page buffer 54 based on a column address C_ADDR provided from the control logic 58. During a read operation, the data input and output circuit 56 may provide, to the memory controller, read data DATA stored in the page buffer 54, based on the column address C_ADDR provided form the control logic 58. The data input and output circuit 56 may transmit, to the control logic 58 or the row decoder 52, an input address or instruction.

The control logic 58 may receive the command CMD and the control signal CTRL from the memory controller. The control logic 58 may provide a row address R_ADDR to the row decoder 52 and a column address C_ADDR to the data input and output circuit 56. The control logic 58 may generate, in response to the control signal CTRL, various internal control signals used in the integrated circuit device 100. For example, the control logic 58 may adjust a voltage level provided to the word line WL and the bit line BL during a memory operation, such as a program operation or an erase operation.

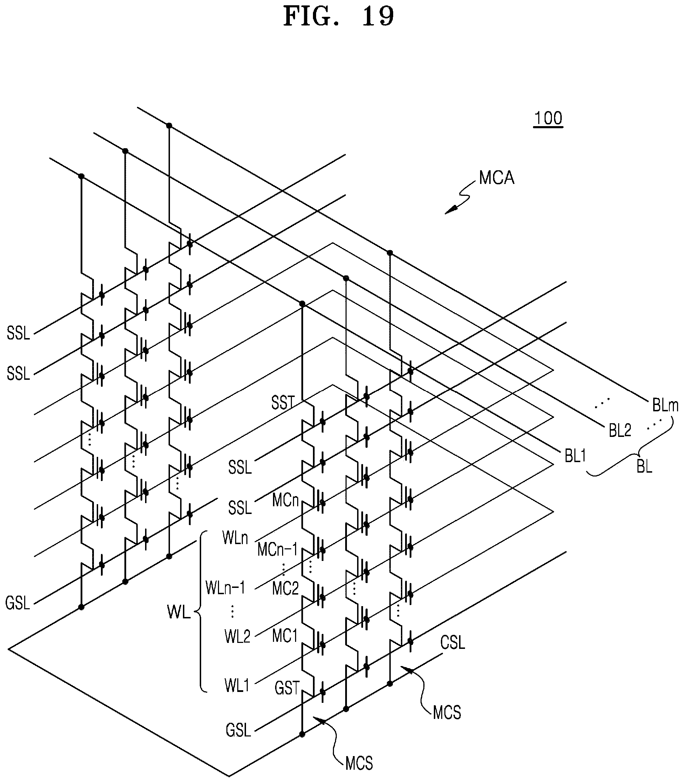

FIG. 19 is an equivalent circuit diagram of a memory cell array of a three-dimensional integrated circuit device according to an embodiment.

FIG. 19 illustrates an equivalent circuit diagram of a vertical NAND flash memory device having a vertical channel structure.

In the integrated circuit device 100 according to embodiments of the inventive concept, a memory cell array MCA may include a plurality of memory cell strings MCS. The memory cell array MCA may include a plurality of bit lines BL (BL1, BL2, ..., BLm), a plurality of word lines WL (WL1, WL2, ..., WLn-1 and WLn), at least one string selection line SSL, at least one ground selection line GSL, and a common source line CSL.

The plurality of memory cell strings MCS may be formed between the plurality of bit lines BL and the common source line CSL. FIG. 19 illustrates an example in which each of the plurality of memory cell strings MCS includes two string selection lines SSL. However, the inventive concept is not limited thereto. For example, each of the plurality of memory cell strings MCS may include one string selection line SSL.

Each of the plurality of memory cell strings MCS may include a string selection transistor SST, a ground selection transistor GST, and a plurality of memory cell transistors MC1, MC2, ..., MCn-1, and MCn. A drain area of the string selection transistor SST may be connected to the bit line BL, and a source area of the ground selection transistor GST may be connected to the common source line CSL. The common source line CSL may be an area to which source areas of the plurality of ground selection transistors GST are commonly connected.

The string selection transistor SST may be connected to the string selection line SSL, and the ground selection transistor GST may be connected to the ground selection line GSL. The plurality of memory cell transistors MC1, MC2, ..., MCn-1, and MCn may be connected to the plurality of word lines WL, respectively. The vertical NAND flash memory device may be connected to a peripheral circuit, which includes one or more planar transistors having the structure of any of FIGS. 1-6.

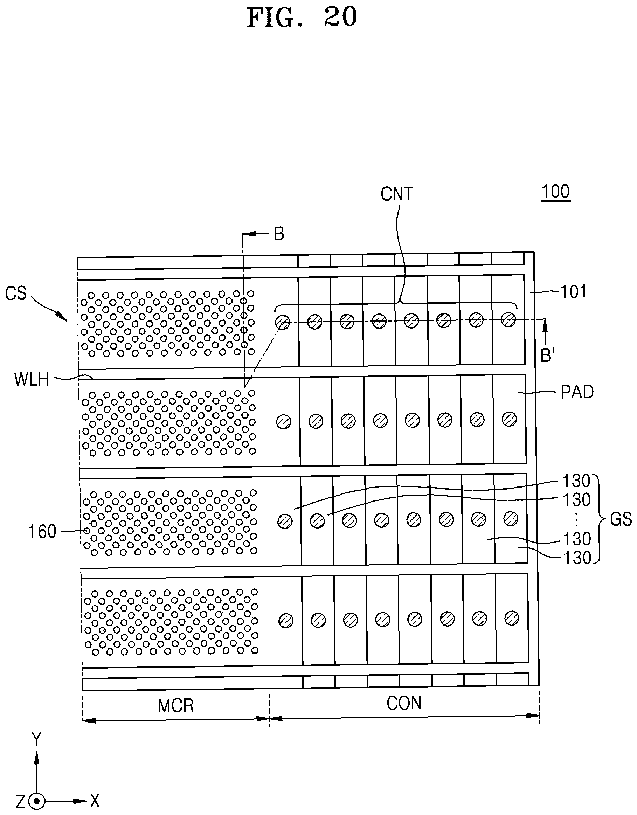

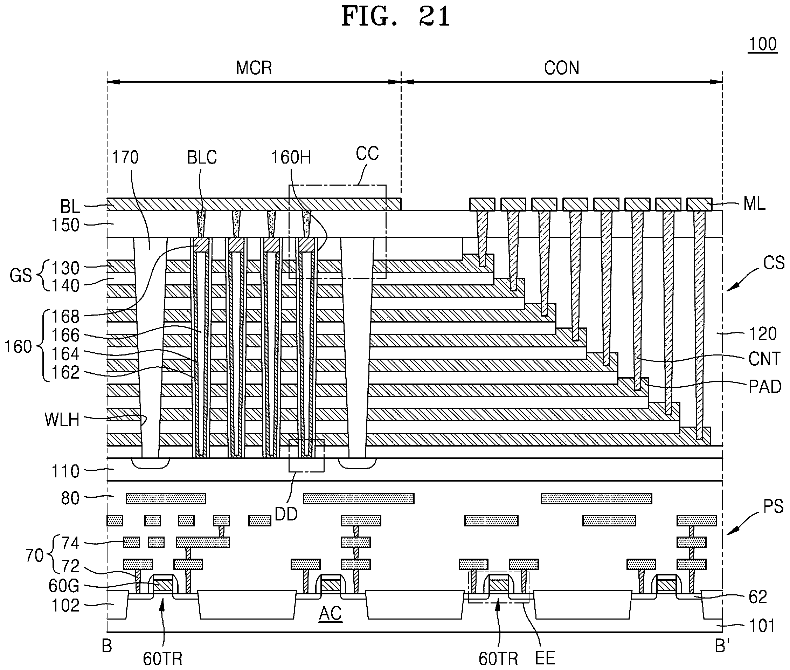

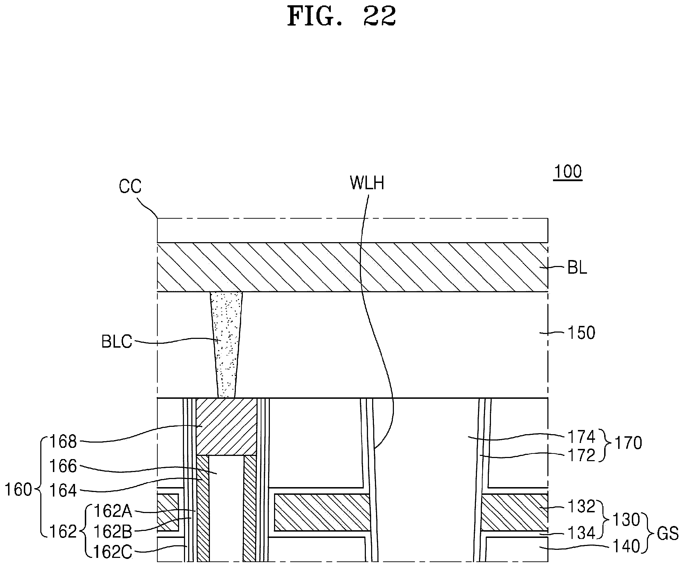

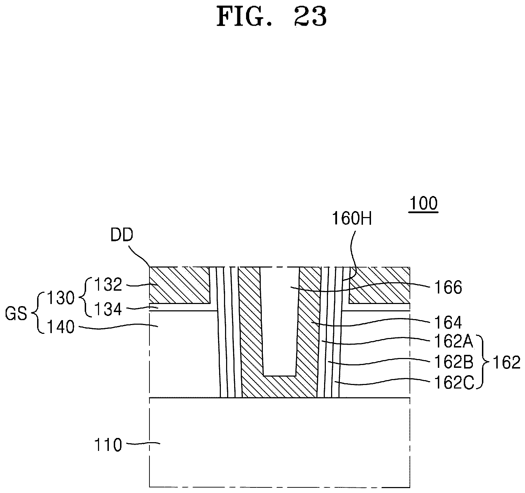

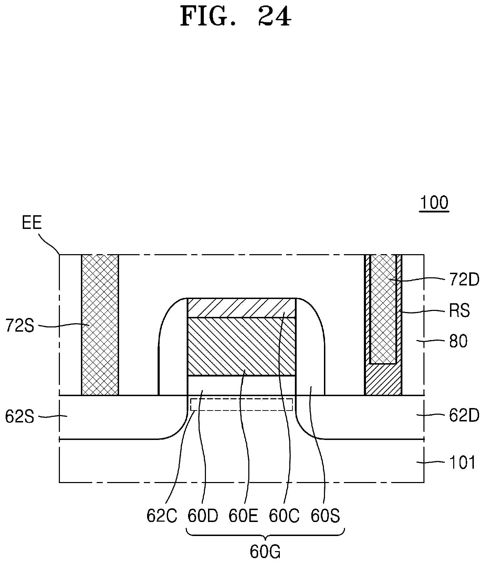

FIG. 20 is a schematic plan view of structural elements of a three-dimensional integrated circuit device according to an embodiment. FIG. 21 is a cross-sectional view of the three-dimensional integrated circuit device of FIG. 20, taken along line B-B'. FIG. 22 is an enlarged view of region CC of FIG. 21. FIG. 23 is an enlarged view of region DD of FIG. 21. FIG. 24 is an enlarged view of region EE of FIG. 21. In one embodiment, FIG. 20 depicts a schematic plan view of structural elements that make up the integrated circuit device 100 of FIG. 18 when implementing the vertical NAND flash memory device of FIG. 19.

Referring to FIGS. 20 to 24 together, the integrated circuit device 100 may include a peripheral circuit structure PS and a cell array structure CS arranged at a higher vertical level than the peripheral circuit structure PS.

The integrated circuit device 100 according to an embodiment may have a cell on periphery (COP) structure in which a cell array structure CS is arranged on a peripheral circuit structure PS. A base structure 110 may be arranged between the peripheral circuit structure PS and the cell array structure CS.

The peripheral circuit structure PS may include a peripheral circuit transistor 60TR and a peripheral circuit line 70 arranged on the substrate 101. An active area AC may be defined on the substrate 101 by a device isolation layer 102, and a plurality of peripheral circuit transistors 60TR may be formed in the active area AC. The plurality of peripheral circuit transistors 60TR may include a gate structure 60G, and a source/drain area 62 arranged at both sides of the gate structure 60G on a portion of the substrate 101.

In the integrated circuit device 100 according to an embodiment, some of the plurality of peripheral circuit transistors 60TR arranged in the peripheral circuit structure PS (as shown, for example in FIG. 24) may include at least one of the integrated circuit devices 10, 20, 30, and 40 described above.

The peripheral circuit line 70 may include a plurality of peripheral circuit contacts 72 and a plurality of peripheral circuit metal layers 74. An interlayer insulating layer 80 covering the peripheral circuit transistor 60TR and the peripheral circuit line 70 may be arranged on the substrate 101. The plurality of peripheral circuit metal layers 74 may have a multi-layered structure including a plurality of metal layers arranged at different vertical levels. It is illustrated in FIG. 21 that all of the plurality of peripheral circuit metal layers 74 are formed to have the same height as each other (e.g., same vertical thickness). However, unlike this, the peripheral circuit metal layer 74 arranged at some levels (for example, an uppermost level) may be formed to have a greater thickness than the peripheral circuit metal layers 74 arranged at the other levels.

A gate stack GS may extend on the base structure 110 in a first direction (an X direction) and a second direction (a Y direction) which are parallel with a planar surface of the substrate 101. The gate stack GS may include a plurality of gate electrodes 130 and a plurality of insulating layers 140, and the plurality of gate electrodes 130 and the plurality of insulating layers 140 may be alternately arranged on an upper surface of the base structure 110 in a vertical direction (a Z direction). Also, an upper insulating layer 150 may be arranged on an uppermost portion of the gate stack GS.

Each gate electrode 130 may include a buried conductive layer 132, and an insulating liner 134 surrounding an upper surface, a bottom surface, and a side surface of the buried conductive layer 132. For example, the buried conductive layer 132 may include metal such as tungsten, metal silicide such as tungsten silicide, doped polysilicon, or a combination thereof. According to some embodiments, the insulating liner 134 may include a high-dielectric material such as aluminum oxide.

The plurality of gate electrodes 130 may correspond to the ground selection line GSL, the word line WL, and the at least one string selection line SSL included in the memory cell string MCS described above with reference to FIG. 19. For example, the gate electrode 130 at a lowermost layer may function as the ground selection line GSL, the gate electrode 130 at an uppermost layer may function as the string selection line SSL, and the other gate electrodes 130 may function as the word line WL. Accordingly, the memory cell string MCS in which the ground selection transistor GST, the string selection transistor SST, and the memory cell transistors MC1, MC2, ..., MCn-1, and MCn therebetween are serially connected to one another may be provided.

A plurality of word line cuts 170 may extend on the base structure 110 in the first direction (the X direction). The gate stack GS arranged between a pair of word line cuts 170 may form one block, and the pair of word line cuts 170 may define a width of the gate stack GS in the second direction (the Y direction). The word line cuts 170 may include an insulating spacer 172 and an insulating isolation layer 174. As such, the word line cuts 170 may include an insulating structure.

In a memory cell region MCR, a plurality of channel structures 160 may extend from an upper surface of the base structure 110 in the vertical direction (the Z direction) by passing through the gate stack GS. The plurality of channel structures 160 may be arranged to be apart from each other by a certain distance in the first direction (the X direction) and the second direction (the Y direction). The plurality of channel structures 160 may be arranged in a zigzag shape or a staggered shape.

The plurality of channel structures 160 may extend in a channel hole 160H passing through the gate stack GS. Each of the plurality of channel structures 160 may include a gate insulating layer 162, a channel layer 164, a buried insulating layer 166, and a conductive plug 168. The gate insulating layer 162 and the channel layer 164 may be sequentially arranged on a side wall of the channel hole 160H. For example, the gate insulating layer 162 may be conformally arranged on the side wall of the channel hole 160H, and the channel layer 164 may be conformally arranged on the side wall and a bottom portion of the channel hole 160H. The buried insulating layer 166 may fill a remaining space of the channel hole 160H on the channel layer 164. The conductive plug 168 in contact with the channel layer 164, the conductive plug 168 blocking an entrance (for example, an uppermost end) of the channel hole 160H, may be arranged at an upper portion of the channel hole 160H. According to other embodiments, the buried insulating layer 166 may be omitted and the channel layer 164 may fill a remaining portion of the channel hole 160H, in a pillar shape.

The gate insulating layer 162 may have a structure in which a tunneling dielectric layer 162A, a charge storage layer 162B, and a blocking dielectric layer 162C are sequentially provided on an outer side wall of the channel layer 164. Relative thicknesses of the tunneling dielectric layer 162A, the charge storage layer 162B, and the blocking dielectric layer 162C included in the gate insulating layer 162 are not limited to the illustration and may be variously changed.

The tunneling dielectric layer 162A may include silicon oxide, hafnium oxide, aluminum oxide, zirconium oxide, tantalum oxide, or the like. The charge storage layer 162B may be where electrons passing through the tunneling dielectric layer 162A from the channel layer 164 may be stored and may include silicon nitride, boron nitride, silicon boron nitride, or polysilicon doped with impurities. The blocking dielectric layer 162C may include silicon oxide, silicon nitride, or metal oxide having a greater dielectric rate than silicon oxide.

The gate electrode 130 at an uppermost portion in one block may be, in a plan view, isolated into two portions by a string isolation insulating layer (not shown). The two portions of the gate electrode 130 may form the string selection line SSL described above with reference to FIG. 2.

In a connection area CON, the gate electrode 130 may extend to form a pad portion PAD at an end of the gate electrode 130, and a cover insulating layer 120 covering the pad portion PAD may be arranged. In the connection area CON, the plurality of gate electrodes 130 may extend to have a decreased length in the first direction (the X direction), away, in the vertical direction (the Z direction), from the upper surface of the base structure 110. The plurality of gate electrodes 130 may have a stair structure in the connection area CON.

In the connection area CON, a contact plug CNT may pass through the cover insulating layer 120 and be connected to the pad portion PAD of the gate electrode 130. The contact plug CNT may have a tapered cylindrical shape having a decreased width in the vertical direction (the Z direction) from an upper portion thereof to a lower portion thereof.

A bit line contact BLC may pass through the upper insulating layer 150 and may be in contact with the conductive plug 168 of the channel structure 160, and the bit line BL in contact with the bit line contact BLC may extend in the second direction (the Y direction) on the upper insulating layer 150. Also, a conductive line ML may be formed on the upper insulating layer 150 in the connection area CON. Although not shown, an upper support layer may further be formed between the upper insulating layer 150 and the bit line BL and between the upper insulating layer 150 and the conductive line ML.

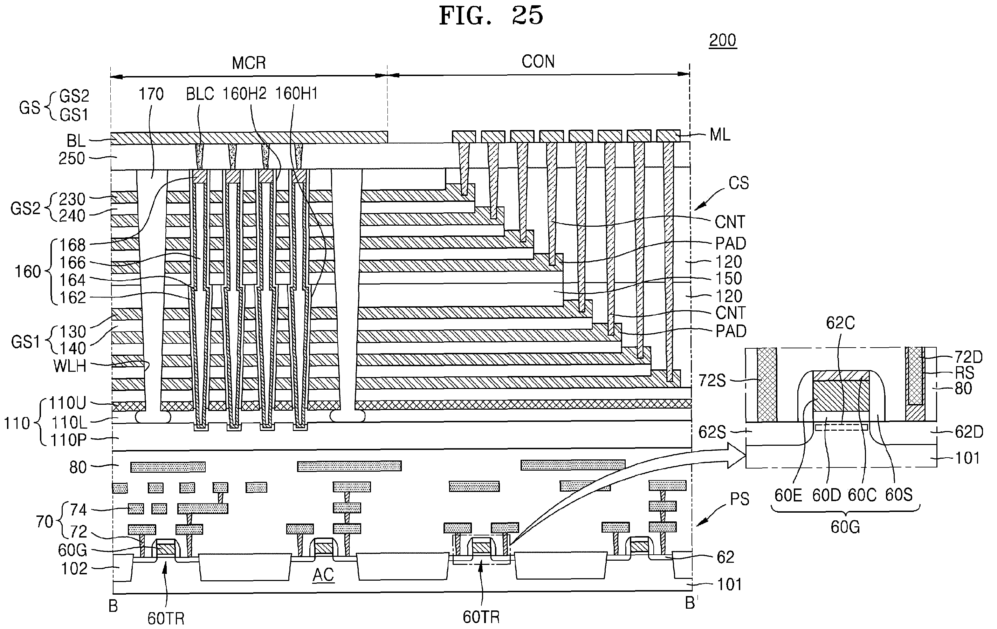

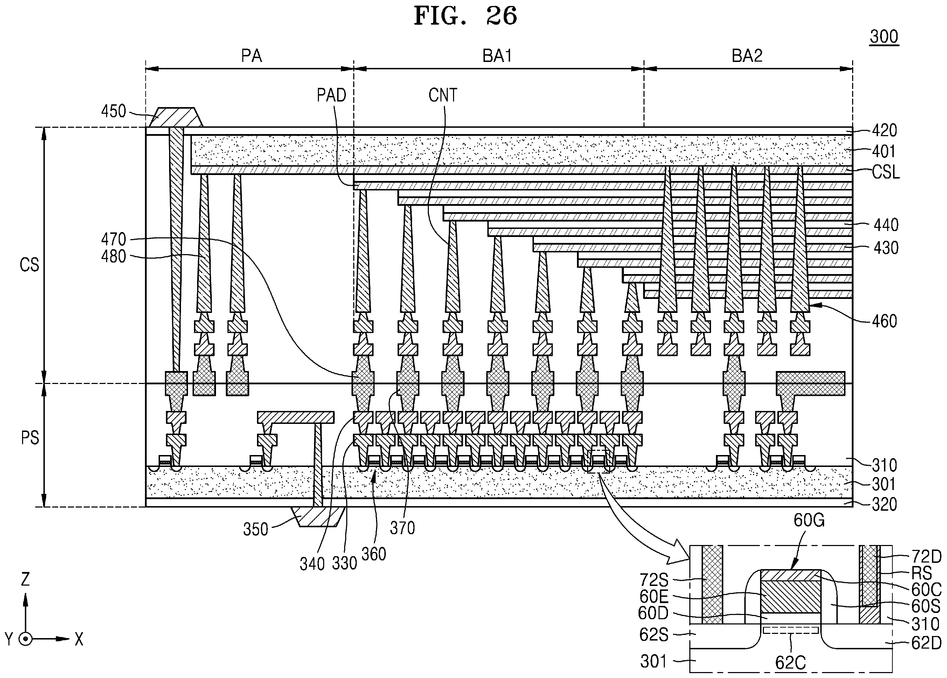

FIGS. 25 and 26 are cross-sectional views of a three-dimensional integrated circuit device according to another embodiment.

Referring to FIG. 25, an integrated circuit device 200 may include a first gate stack GS1 at a lower potion thereof and a second gate stack GS2 at an upper portion thereof.

In the integrated circuit device 200 according to an embodiment, the first gate stack GS1 may include a plurality of first gate electrodes 130 and a plurality of first insulating layers 140, and the plurality of first gate electrodes 130 and the plurality of first insulating layers 140 may be alternately arranged on an upper surface of the base structure 110 in a vertical direction (a Z direction). Also, a first upper insulating layer 150 may be arranged on an uppermost portion of the first gate stack GS1.

The second gate stack GS2 may include a plurality of second gate electrodes 230 and a plurality of second insulating layers 141, and the plurality of second gate electrodes 230 and the plurality of second insulating layers 141 may be alternately arranged above the first gate stack GS1 in the vertical direction (the Z direction). Also, a second upper insulating layer 250 may be arranged on an uppermost portion of the second gate stack GS2.

The plurality of channel structures 160 may extend in a first channel hole 160H1 passing through the first gate stack GS1 and a second channel hole 160H2 passing through the second gate stack GS2. The plurality of channel structures 160 may have a shape outwardly protruding from a boundary portion between the first channel hole 160H1 and the second channel hole 160H2.

The base structure 110 may include an upper base layer 110U, a lower base layer 110L, and a plate layer 110P. The plurality of channel structures 160 may pass through an upper base layer 110U and a lower base layer 110L of the base structure 110 and may be in contact with the plate layer 110P of the base structure 110. Thus, the channel layer 164 may be electrically connected to the lower base layer 110L, rather than being in contact with the plate layer 110P.

In the integrated circuit device 200 according to an embodiment, the peripheral circuit structure PS may include the peripheral circuit transistor 60TR and the peripheral circuit line 70 arranged on the substrate 101. The active area AC may be defined on the substrate 101 by the device isolation layer 102, and a plurality of peripheral circuit transistors 60TR may be formed in the active area AC. The plurality of peripheral circuit transistors 60TR may include the gate structure 60G, which is a peripheral circuit gate, and the source/drain area 62 (e.g., 62S and 62D) arranged at opposite sides of the gate structure 60G on a portion of the substrate 101.

In the integrated circuit device 200 according to an embodiment, some of the plurality of peripheral circuit transistors 60TR arranged in the peripheral circuit structure PS may include at least one of the integrated circuit devices 10, 20, 30, and 40 described above.

Referring to FIG. 26, an integrated circuit device 300 may include a chip-to-chip bonding structure.

The integrated circuit device 300 according to an embodiment may include a chip-to-chip bonding structure, in which an upper chip and a lower chip are connected to each other by a bonding method, after the upper chip including the cell array structure CS is manufactured and the lower chip including the peripheral circuit structure PS is manufactured.

According to some embodiments, the bonding method may denote a method of bonding a bonding pad formed at an uppermost portion of the upper chip with a bonding pad formed at an uppermost portion of the lower chip. The bonding method may include a metal-metal bonding structure, a through silicon via (TSV), a back via stack (BVS), a eutectic bonding structure, a ball grid array (BGA) bonding structure, a plurality of lines, or a combination thereof.

The peripheral circuit structure PS may include a circuit substrate 301, an interlayer insulating layer 310, a plurality of circuit devices 360, a first metal layer 330 connected to each of the plurality of circuit devices 360, and a second metal layer 340 formed on the first metal layer. The interlayer insulating layer 310 may be arranged on the circuit substrate 301 to cover the plurality of circuit devices 360, the first metal layer 330, and the second metal layer 340 and may include an insulating material.

In the integrated circuit device 300 according to an embodiment, some of the plurality of circuit devices 360 arranged in the peripheral circuit structure PS may include at least one of the integrated circuit devices 10, 20, 30, and 40 described above.

A lower bonding pad 370 may be formed on the second metal layer 340 of a word line bonding area BA1. In the word line bonding area BA1, the lower bonding pad 370 of the peripheral circuit structure PS may be electrically connected to an upper bonding pad 470 of the cell array structure CS by a bonding method.

The cell array structure CS may include at least one memory block. The cell array structure CS may include a cell substrate 401 and a common source line CSL. A plurality of word lines 430 and a plurality of insulating layers 440 may be stacked on the cell substrate 401 in a vertical direction (a Z direction).

In a bit line bonding area BA2, a channel structure 460 may pass through the word lines 430, the insulating layers 440, string selection lines, and a ground selection line in the vertical direction (the Z direction).

In the word line bonding area BA1, the word lines 430 may extend in parallel with an upper surface of the cell substrate 401 and may be connected to a plurality of contact plugs CNT. The word lines 430 and the contact plugs CNT may be connected to each other in a pad portion PAD provided by some of the word lines 430 extending to have different lengths from one another.

A common source line contact 480 may be arranged in an external pad bonding area PA. The common source line contact 480 may include a conductive material, such as metal, a metal compound, polysilicon, or the like, and may be electrically connected to the common source line CSL.

Input and output pads 350 and 450 may be arranged in the external pad bonding area PA. A lower layer 320 covering a lower surface of a circuit substrate 301 may be formed below the circuit substrate 301 and a first input and output pad 350 may be formed on the lower layer 320. An upper layer 420 covering an upper surface of the cell substrate 401 may be formed above the cell substrate 401 and a second input and output pad 450 may be arranged on the upper layer 420.

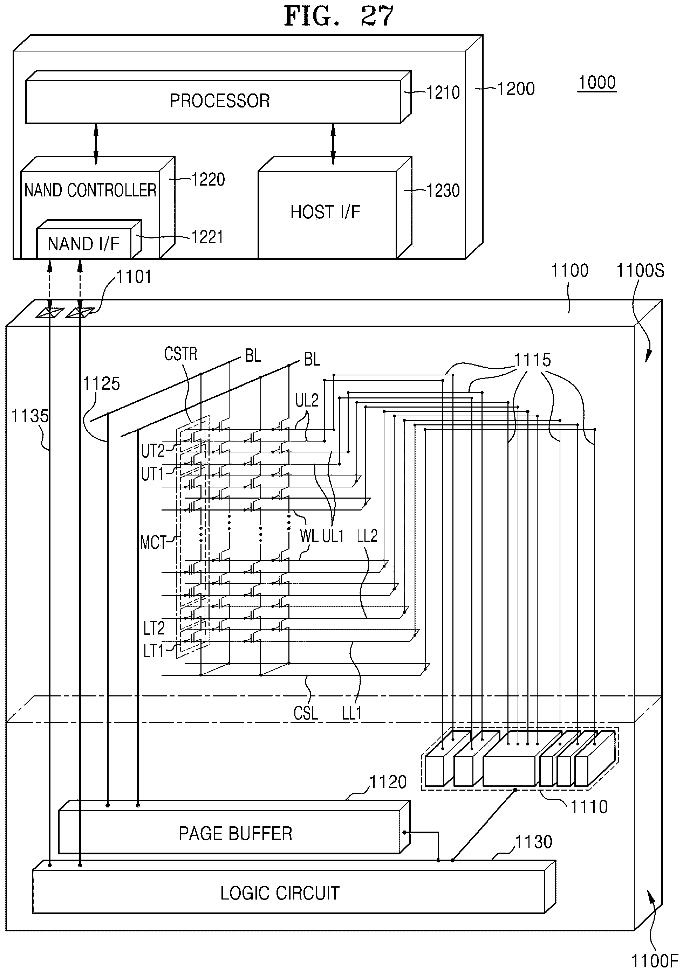

FIG. 27 is a diagram of an electronic system 1000 including an integrated circuit device 1100, according to an embodiment.

Referring to FIG. 27, the electronic system 1000 according to an embodiment of the inventive concept may include the integrated circuit device 1100 and a controller 1200 electrically connected to the integrated circuit device 1100.

The electronic system 1000 may include a storage device including one or more integrated circuit devices 1100 or an electronic device including the storage device. For example, the electronic system 1000 may include a solid state drive (SSD) device, a universal serial bus (USB), a computing system, a medical device, or a communication device including at least one integrated circuit device 1100.

The integrated circuit device 1100 may include a nonvolatile vertical memory device. For example, the integrated circuit device 1100 may include a NAND flash memory device including at least one of the integrated circuit devices 100, 200, and 300 described above with reference to FIGS. 18 to 26. The integrated circuit device 1100 may include a first structure 1100F and a second structure 1100S on the first structure 1100F. According to some embodiments, the first structure 1100F may be arranged beside the second structure 1100S.

The first structure 1100F may include a peripheral circuit structure including a decoder circuit 1110, a page buffer 1120, and a logic circuit 1130. The second structure 1100S may include a memory cell structure including a bit line BL, a common source line CSL, a plurality of word lines WL, first and second gate upper lines UL1 and UL2, first and second gate lower lines LL1 and LL2, and a plurality of memory cell strings CSTR between the bit line BL and the common source line CSL.

Each of the plurality of memory cell strings CSTR in the second structure 1100S may include lower transistors LT1 and LT2 adjacent to the common source line CSL, upper transistors UT1 and UT2 adjacent to the bit line BL, and a plurality of memory cell transistors MCT arranged between the lower transistors LT1 and LT2 and the upper transistors UT1 and UT2. The number of lower transistors LT1 and LT2 and the number of upper transistors UT1 and UT2 may be variously changed according to embodiments.

According to some embodiments, the upper transistors UT1 and UT2 may include string selection transistors and the lower transistors LT1 and LT2 may include ground selection transistors. The plurality of gate lower lines LL1 and LL2 may be gate layers of the lower transistors LT1 and LT2, respectively. The word line WL may be a gate layer of the memory cell transistor MCT, and the gate upper lines UL1 and UL2 may be gate layers of the upper transistors UT1 and UT2, respectively.

The common source line CSL, the plurality of gate lower lines LL1 and LL2, the plurality of word lines WL, and the plurality of gate upper lines UL1 and UL2 may be electrically connected to the decoder circuit 1110 through a plurality of first connection lines 1115 extending in the first structure 1100F to the second structure 1100S. The plurality of bit lines BL may be electrically connected to the page buffer 1120 through a plurality of second connection lines 1125 extending in the first structure 1100F to the second structure 1100S.

In the first structure 1100F, the decoder circuit 1110 and the page buffer 1120 may perform a control operation on at least one of the plurality of memory cell transistors MCT. The decoder circuit 1110 and the page buffer 1120 may be controlled by the logic circuit 1130.

The integrated circuit device 1100 may communicate with the controller 1200 through an input and output pad 1101 electrically connected to the logic circuit 1130. The input and output pad 1101 may be electrically connected to the logic circuit 1130 through an input and output connection line 1135 extending in the first structure 1100F to the second structure 1100S.

The controller 1200 may include a processor 1210, a NAND controller 1220, and a host interface 1230. According to some embodiments, the electronic system 1000 may include a plurality of integrated circuit devices 1100, and in this case, the controller 1200 may control the plurality of integrated circuit devices 1100.

The processor 1210 may control general operations of the electronic system 1000 including the controller 1200. The processor 1210 may operate according to certain firmware and may control the NAND controller 1220 and may access the integrated circuit device 1100. The NAND controller 1220 may include a NAND interface 1221 configured to process communication with the integrated circuit device 1100. Through the NAND interface 1221, a control command for controlling the integrated circuit device 1100, data to be written to the plurality of memory cell transistors MCT of the integrated circuit device 1100, data to be read from the plurality of memory cell transistors MCT of the integrated circuit device 1100, etc. may be transmitted. The host interface 1230 may provide a communication function between the electronic system 1000 and an external host. When a control command is received from the external host through the host interface 1230, the processor 1210 may control the integrated circuit device 1100 in response to the control command.

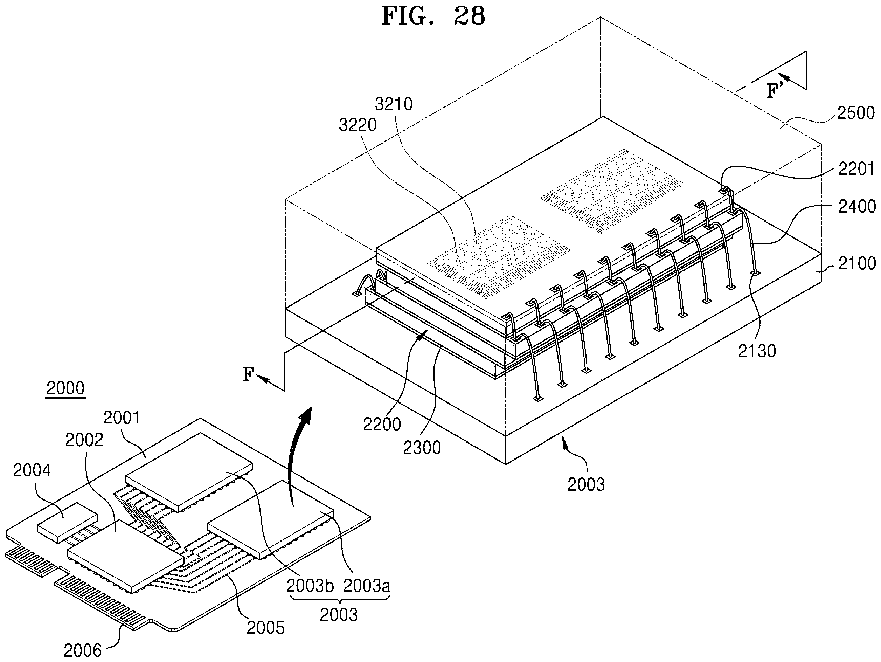

FIG. 28 is a perspective view of an electronic system 2000 including an integrated circuit device, according to an embodiment.

Referring to FIG. 28, the electronic system 2000 according to an embodiment may include a main substrate 2001, a controller 2002 mounted on the main substrate 2001, one or more semiconductor packages 2003, and dynamic random-access memory (DRAM) 2004.

The main substrate 2001 may include a connector 2006 including a plurality of pins coupled to an external host. The number and the arrangement of the plurality of pins of the connector 2006 may vary according to a communication interface between the electronic system 2000 and the external host. According to some embodiments, the electronic system 2000 may communicate with an external host according to any one of interfaces, such as USB, peripheral component interconnect express (PCI-express), serial advanced technology attachment (SATA), M-Phy for a universal flash storage (UFS), etc. According to some embodiments, the electronic system 2000 may operate based on power supplied from an external host through the connector 2006. The electronic system 2000 may further include a power management integrated circuit (PMIC) configured to distribute the power supplied from the external host to the controller 2002 and the semiconductor package 2003. The semiconductor package 2003 and the DRAM 2004 may be connected to the controller 2002 by a plurality of line patterns 2005 formed on the main substrate 2001.

The controller 2002 may write data to the semiconductor package 2003 or read data from the semiconductor package 2003 and may improve the operation speed of the electronic system 2000.

The DRAM 2004 may include a buffer memory configured to reduce a difference in speed between an external host and the semiconductor package 2003, which is a data storage space. The DRAM 2004 included in the electronic system 2000 may also operate as a type of cache memory and may provide a space for temporarily storing data in a control operation on the semiconductor package 2003. When the DRAM 2004 is included in the electronic system 2000, the controller 2002 may further include a DRAM controller configured to control the DRAM 2004, in addition to the NAND controller 1220 configured to control the semiconductor package 2003.

The semiconductor package 2003 may include first and second semiconductor packages 2003a and 2003b which are apart from each other. Each of the first and second semiconductor packages 2003a and 2003b may include a plurality of semiconductor chips 2200. Each of the first and second semiconductor packages 2003a and 2003b may include a package substrate 2100, the plurality of semiconductor chips 2200 on the package substrate 2100, a bonding layer 2300 arranged on a lower surface of each of the plurality of semiconductor chips 2200, a connection structure 2400 electrically connecting the plurality of semiconductor chips 2200 with the package substrate 2100, and a molding layer 2500 covering the plurality of semiconductor chips 2200 and the connection structure 2400 on the package substrate 2100.

The package substrate 2100 may include a printed circuit board including a plurality of upper pads 2130. Each of the plurality of semiconductor chips 2200 may include an input and output pad 2201. The input and output pad 2201 may correspond to the input and output pad 1101 of FIG. 27. Each of the plurality of semiconductor chips 2200 may include a plurality of gate stacks 3210 and a plurality of channel structures 3220. The plurality of semiconductor chips 2200 may include at least one of the integrated circuit devices 100, 200, and 300 described above with reference to FIGS. 18 to 26.

According to some embodiments, the connection structure 2400 may include bonding wires electrically connecting the input and output pads 2201 with the upper pads 2130. Thus, in the first and second semiconductor packages 2003a and 2003b, the plurality of semiconductor chips 2200 may be electrically connected to each other by a bonding wire method and may be electrically connected to the upper pads 2130 of the package substrate 2100. According to some embodiments, in the first and second semiconductor packages 2003a and 2003b, the plurality of semiconductor chips 2200 may be electrically connected to each other by a connection structure including a TSV, rather than by the connection structure 2400 using the bonding wire method.

According to some embodiments, the controller 2002 and the plurality of semiconductor chips 2200 may be included in one package. According to some embodiments, the controller 2002 and the plurality of semiconductor chips 2200 may be mounted on an interposer substrate which is different from the main substrate 2001, and the controller 2002 and the plurality of semiconductor chips 2200 may be connected to each other through a line formed on the interposer substrate.

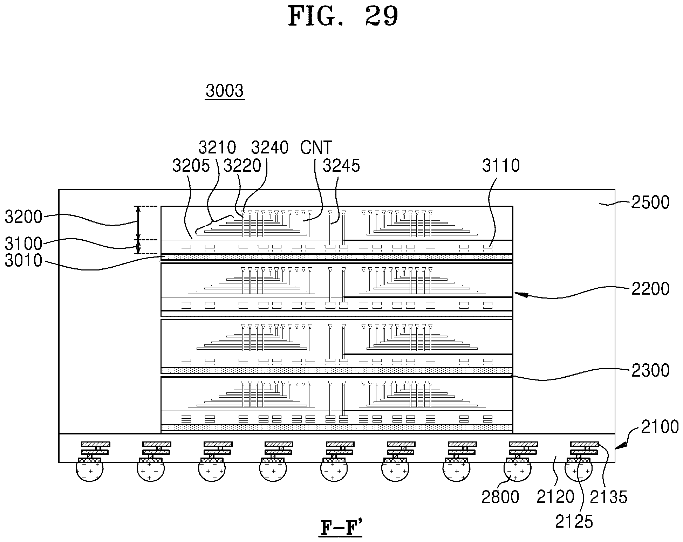

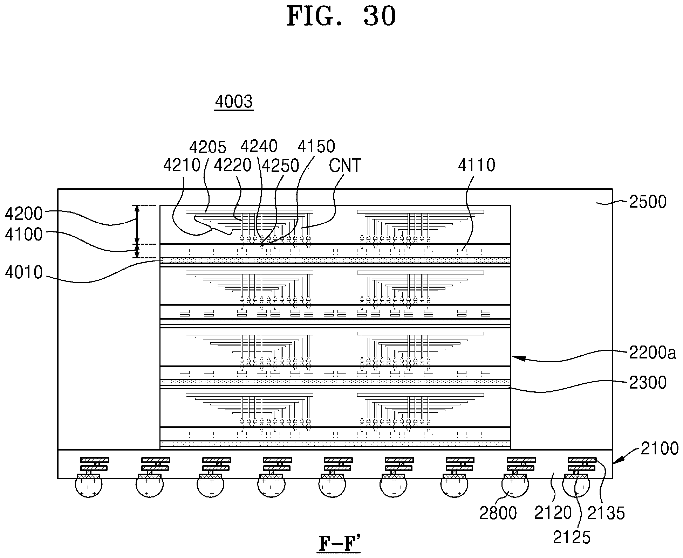

FIGS. 29 and 30 are cross-sectional views of a semiconductor package 3003 including an integrated circuit device, according to an embodiment.

In detail, FIGS. 29 and 30 are cross-sectional views showing, in detail, the structure of the electronic system of FIG. 28, taken along line F-F'.

Referring to FIG. 29, in the semiconductor package 3003, the package substrate 2100 may include a printed circuit board.

The package substrate 2100 may include a body portion 2120, the plurality of upper pads 2130 (see FIG. 28) arranged on an upper surface of the body portion 2120, a plurality of lower pads 2125 arranged on a lower surface of the body portion 2120 or exposed through the lower surface of the body portion 2120, and a plurality of inner lines 2135 electrically connecting the plurality of upper pads 2130 with the plurality of lower pads 2125 in the body portion 2120. The plurality of upper pads 2130 may be electrically connected to the plurality of connection structures 2400 (see FIG. 28). The plurality of lower pads 2125 may be connected, through a plurality of conductive connecting portions 2800, to the plurality of line patterns 2005 on the main substrate 2001 of the electronic system 2000 illustrated in FIG. 28.

Each of the plurality of semiconductor chips 2200 may include a substrate 3010, and a first structure 3100 and a second structure 3200 sequentially stacked on the substrate 3010. The first structure 3100 may include a peripheral circuit area including a plurality of peripheral lines 3110. The second structure 3200 may include a common source line 3205, a gate stack 3210 on the common source line 3205, a channel structure 3220 passing through the gate stack 3210, and a bit line 3240 electrically connected to the channel structure 3220.

Each of the plurality of semiconductor chips 2200 may include a penetration line 3245 electrically connected to the plurality of peripheral lines 3110 of the first structure 3100 and extending into the second structure 3200. The penetration 3245 may be arranged at an outer portion of the gate stack 3210. According to some embodiments, the semiconductor package 3003 may further include a penetration line passing through the gate stack 3210. Each of the plurality of semiconductor chips 2200 may further include the input and output pad 2201 (see FIG. 28) electrically connected to the plurality of peripheral lines 3110 of the first structure 3100.

Referring to FIG. 30, a semiconductor package 4003 may have substantially the same structure as the semiconductor package 3003 described with reference to FIG. 29. However, the semiconductor package 4003 may include a plurality of semiconductor chips 2200a.

Each of the plurality of semiconductor chips 2200a may include a substrate 4010, a first structure 4100 on the substrate 4010, and a second structure 4200 bonded to the first structure 4100 on the first structure 4100 through a wafer bonding method. The first structure 4100 may include a peripheral circuit area including a peripheral line 4110 and a plurality of first bonding structures 4150. The second structure 4200 may include a common source line 4205, a gate stack 4210 between the common source line 4205 and the first structure 4100, and a channel structure 4220 passing through the gate stack 4210.

Also, each of the plurality of semiconductor chips 2200a may include a plurality of second bonding structures 4250 respectively electrically connected to a plurality of gate layers of the gate stack 4210. For example, some of the plurality of second bonding structures 4250 may be connected to a bit line 4240 electrically connected to the channel structure 4220. The others of the plurality of second bonding structures 4250 may be electrically connected to the gate layers through a plurality of contact plugs CNT.

The plurality of first bonding structures 4150 of the first structure 4100 and the plurality of second bonding structures 4250 of the second structure 4200 may be in contact with each other and bonded to each other. Bonded portions of the plurality of first bonding structures 4150 and the plurality of second bonding structures 4250 may include metal, for example, Cu, but are not limited thereto.

## Claims

1. An integrated circuit device (10-100) comprising:
a substrate (101);
a channel area (62C) arranged in the substrate (101);
a gate structure (60G) arranged on the channel area (62C) and comprising a gate dielectric layer (60D), a gate electrode (60E), and a gate capping layer (60C), which are sequentially stacked, and first and second gate spacers (60S) on first and second respective opposite side walls of the gate dielectric layer (60D), the gate electrode (60E), and the gate capping layer (60C);
a source area (62S) and a drain area (62D) arranged at opposite sides of the channel area (62C);
a source contact (72S) contacting the source area (62S);
a resistance structure (RS) contacting the drain area (62D) and including doped polysilicon; and
a drain contact (72D) contacting the resistance structure (RS) and including metal.

2. The integrated circuit device (10-100) of claim 1, wherein the resistance structure (RS) is a resistor via having a resistance higher than that of the drain contact (72D); and
a silicide layer is not provided at an interface between the resistance structure (RS) and the drain contact (72D).

3. The integrated circuit device (10-100) of claim 1 or 2, wherein the source contact (72S) includes the same metal included in the drain contact (72D) and does not include the doped polysilicon included in the resistance structure (RS).

4. The integrated circuit device (10, 20) of any one of claims 1 to 3, wherein:
when viewed in a cross-sectional view from a horizontal direction, the resistance structure (RS, RS2) has a U-shape having a groove at a center thereof,
the drain contact (72D, 72D2) fills the groove of the resistance structure (RS, RS2),
a vertical level of an uppermost surface of the resistance structure (RS, RS2) and a vertical level of an uppermost surface of the drain contact (72D, 72D2) are the same as each other, and
a first maximum width of the resistance structure (RS, RS2) in a horizontal direction is greater than a second maximum width of the drain contact (RS, RS2) in the horizontal direction.

5. The integrated circuit device (10, 20) of claim 4, wherein the resistance structure (RS, RS2) comprises a bottom portion and opposite side walls arranged on the bottom portion, and
a thickness of the bottom portion of the resistance structure (RS, RS2) in a vertical direction is greater than a width of any one of the opposite side walls of the resistance structure (RS, RS2) in the horizontal direction.

6. The integrated circuit device (20) of claim 4 or 5, wherein:
the source contact (72S) contacts the source area (62S) at an uppermost surface of the source area (62S),
the resistance structure (RS2) vertically and downwardly extends beyond an uppermost surface of the drain area (62D), and
a vertical level of a lowermost surface of the source contact (72S) is higher than a vertical level of a lowermost surface of the resistance structure (RS2).

7. The integrated circuit device (40) of any one of claims 1 to 3, wherein:
the resistance structure (RS4) has a rectangular shape when viewed in a cross-sectional view from a horizontal direction, and
the drain contact (72D4) completely covers an uppermost surface of the resistance structure (RS4).

8. The integrated circuit device (30) of any one of claims 1 to 3, wherein:
when viewed in a cross-sectional view from a horizontal direction, the resistance structure (RS3) has a U-shape having a groove at a center thereof,
the drain contact (72D3) fills the groove of the resistance structure (RS3) and is arranged above the resistance structure (RS3), and
a vertical level of an uppermost surface of the resistance structure (RS3) is lower than a vertical level of an uppermost surface of the drain contact (72D3).

9. The integrated circuit device (10-100) of any one of claims 1 to 8, wherein:
the source contact (72S) comprises a source through electrode;
the drain contact (72D) combined with the resistance structure (RS) comprises a drain through electrode, and
a first resistance of the source through electrode is less than a second resistance of the drain through electrode.

10. The integrated circuit device (10-100) of claim 9, wherein the resistance of the resistance structure (RS) is determined by at least one of a doping concentration of the doped polysilicon, a crystal grain size of the doped polysilicon, and a thickness of the doped polysilicon.

11. The integrated circuit device (100) of claim 9 or 10, further comprising:
a peripheral circuit structure (PS); and
a cell array structure (CS) above the peripheral circuit structure (PS),
wherein the peripheral circuit structure (PS) comprises a circuit substrate (301), a peripheral circuit transistor (60T) on the circuit substrate (301), a lower line (LL1, LL2) connected to the peripheral circuit transistor (60T), and a first insulating layer (140) covering the peripheral circuit transistor (60T) and the lower line (LL1, LL2), and
the cell array structure (CS) comprises a gate stack (GS) comprising a plurality of gate electrodes (130) and a plurality of insulating layers (140), the plurality of gate electrodes (130) and the plurality of insulating layers (140) being alternately stacked, a plurality of channel structures (160) extending by passing through the gate stack (GS), and a second insulating layer (141) covering the gate stack (GS),
wherein the peripheral circuit transistor (60T) includes the channel area (62C), the gate structure (60G), the source area (62S), the drain area (62D), the source contact (72S), the drain contact (72D), and the resistance structure (RS).

12. An integrated circuit device (100) comprising:
a peripheral circuit structure (PS); and
a cell array structure (CS) above the peripheral circuit structure (PS),
wherein the peripheral circuit structure (PS) comprises a circuit substrate (301), a peripheral circuit transistor (60T) on the circuit substrate (301), a lower line (LL1, LL2) connected to the peripheral circuit transistor (60T), and a first insulating layer (140) covering the peripheral circuit transistor (60T) and the lower line (LL1, LL2), and
the cell array structure (CS) comprises a gate stack (GS) comprising a plurality of gate electrodes (130) and a plurality of insulating layers (140), the plurality of gate electrodes (130) and the plurality of insulating layers (140) being alternately stacked, a plurality of channel structures (160) extending by passing through the gate stack (GS), and a second insulating layer (141) covering the gate stack (GS),
wherein the peripheral circuit transistor (60T) comprises:
a channel area (62C) arranged in the circuit substrate (301);
a gate structure (60G) arranged on the channel area (62C) and comprising a gate dielectric layer (60D), a gate electrode (60E), and a gate capping layer (60C) which are sequentially stacked, and first and second gate spacers (60S) on first and second respective opposite side walls of the gate dielectric layer (60D), the gate electrode (60E), and the gate capping layer (60C);
a source area (62S) and a drain area (62D) arranged at opposite sides of the channel area (62C);
a source contact (72S) contacting the source area (62S); and
a resistance structure (RS) contacting the drain area (62D) and a drain contact (72D) contacting the resistance structure (RS).

13. The integrated circuit device (100) of claim 12, wherein:
the resistance structure (RS) includes doped polysilicon, and
the source contact (72S) and the drain contact (72D) include the same metal as each other.

14. The integrated circuit device (100) of claim 12 or 13, wherein:
the source contact (72S) comprises a source through electrode;
the drain contact (72D) combined with the resistance structure (RS) comprises a drain through electrode, and
a first resistance of the source through electrode is less than a second resistance of the drain through electrode, and
a silicide layer is not provided at an interface between the resistance structure (RS) and the drain contact (72D).

15. The integrated circuit device (100) of any one of claims 12 to 14, wherein:
the resistance structure (RS) has a cup-shape,
the drain contact (72D) fills a hole (80HD) in the resistance structure (RS),
a vertical level of a lowermost surface of the source contact (72S) is lower than a vertical level of a lowermost surface of the drain contact (72D), and
an uppermost surface of the source contact (72S) is at the same vertical level as an uppermost surface of the drain contact (72D).
